# EUROPEAN PATENT APPLICATION

(11) **EP 4 503 881 A1**
(43) Date of publication of application: **05.02.2025**
(21) Application number: 24190097.6
(22) Date of filing: 22.07.2024
(51) Int. Cl.: H05K 9/00

(54) **ELECTRICAL DEVICE, METHOD FOR ASSEMBLING ELECTRICAL DEVICE, AND VEHICLE COMPRISING THE ELECTRICAL DEVICE**

(30) Priority: 02.08.2023 CN 202310964473
(71) Applicant: Valeo eAutomotive Germany GmbH, 91056 Erlangen (DE)
(72) Inventor: XU, Kangfa, 91056 ERLANGEN (DE); LI, Huipeng, 91056 ERLANGEN (DE)
(74) Representative: Valeo Powertrain Systems

(57) **Abstract**

The present disclosure relates to an electrical device, including: a cover part (1); a printed circuit board (2); and an anti-electromagnetic interference sheet (3). According to the present disclosure, the anti-electromagnetic interference sheet (3) is arranged between the cover part (1) and the printed circuit board (2), and the anti-electromagnetic interference sheet (3) is fixedly connected to the printed circuit board (2) by means of a fastener. The present disclosure also relates to a method for assembling the electrical device and a vehicle including the electrical device.

## Description

### Technical Field

The present disclosure relates to the technical field of electricity, in particular to an electrical device, a method for assembling the electrical device, and a vehicle comprising the electrical device.

### Background

In some electrical devices, electromagnetic radiation will be produced, for example during operation of a case of an on-board electronic system of a vehicle, wherein a source of interference causes its signals to be coupled to other electrical networks through space. In high-speed printed circuit board (PCB) and system design, high-frequency signal lines, integrated circuit pins and various kinds of connectors, etc. may all become radiative interference sources with antenna characteristics, and can emit electromagnetic waves and thus affect the normal operation of other systems, or of other sub-systems within the system in question. To prevent electromagnetic interference (EMI), an anti-electromagnetic interference sheet may be used. However, in the design of an existing electrical device, the anti-electromagnetic interference sheet is often pre-fixed to the PCB first using a tool, and then connected to the corresponding PCB by soldering, but this process is cumbersome and requires more man-hours, as well as having a high cost.

Thus, there is a need for an electrical device with a simpler assembly process and lower cost, in which electromagnetic interference is prevented.

### Summary

In response to the above problem, the present disclosure provides an electrical device and a method for assembling same, and a vehicle comprising the electrical device. Utilizing the electrical device provided in the present disclosure, assembly can be simplified while preventing electromagnetic interference, and a pre-fixing tool and soldering process can be dispensed with, thereby lowering costs.

To solve the technical problems mentioned, the present disclosure provides an electrical device, comprising:
a cover part;
a printed circuit board; and
an anti-electromagnetic interference sheet.

According to the present disclosure, the anti-electromagnetic interference sheet is arranged between the cover part and the printed circuit board, and fixedly connected to the printed circuit board by means of a fastener.

Thus, a firm and reliable fixed connection between the anti-electromagnetic interference sheet and the printed circuit board is accomplished in a simple manner; this is simpler than a soldering process, and avoids after-treatment of solder joints as well as a possible drop in functionality due to poor solder joints during use.

In some embodiments, the anti-electromagnetic interference sheet comprises a plug-in part at a side thereof connected to the printed circuit board, a free end of the plug-in part comprises an elastically deformable extension section, the printed circuit board comprises a groove cooperating with the plug-in part, and the extension section is supported on an inner wall of the groove in a preloaded manner.

Thus, the anti-electromagnetic interference sheet and the printed circuit board are pre-positioned relative to each other before being finally connected together; this makes it easier for the anti-electromagnetic interference sheet to be fixedly connected to the printed circuit board with accurate positioning in a simple process.

In some embodiments, the anti-electromagnetic interference sheet is in threaded connection with the printed circuit board by means of a bolt.

In some embodiments, the anti-electromagnetic interference sheet comprises a bent part at a side thereof connected to the printed circuit board, the bent part comprises a through hole, and the through hole is for the fastener to pass through and corresponds to a mating through hole of the printed circuit board.

In some embodiments, the anti-electromagnetic interference sheet comprises a contact arm at a side thereof connected to the printed circuit board, and the contact arm abuts a surface of the printed circuit board in an installed state of the electrical device.

Reliable contact between the anti-electromagnetic interference sheet and the printed circuit board is thus ensured, thereby eliminating a potential difference therebetween due to poor contact.

In some embodiments, the anti-electromagnetic interference sheet comprises an elastically deformable projection at a side thereof adjacent to the cover part, and a free end of the projection is supported on a surface of the cover part in an elastically preloaded manner in an installed state of the electrical device.

Reliable contact between the anti-electromagnetic interference sheet and the cover part is thus ensured, thereby eliminating a potential difference therebetween due to poor contact.

In some embodiments, the printed circuit board comprises a first electronic element and a second electronic element, the electrical device comprises a first area and a second area, the first electronic element is located in the first area, the second electronic element is located in the second area, and the anti-electromagnetic interference sheet is used to prevent electromagnetic interference between the first electronic element and the second electronic element.

In some embodiments, the anti-electromagnetic interference sheet is designed as a stamping part formed as a single piece.

According to the present disclosure, the anti-electromagnetic interference sheet is made of metal, preferably of copper or brass. Of course, other suitable electrically conductive materials may also be used to make the anti-electromagnetic interference sheet.

To solve the technical problems mentioned, the present disclosure also provides a method for assembling the electrical device, the method comprising:
pre-positioning the anti-electromagnetic interference sheet on the printed circuit board;
fixedly connecting the anti-electromagnetic interference sheet to the printed circuit board by means of a fastener;
mounting the cover part, such that the free end of the projection of the anti-electromagnetic interference sheet is supported on the surface of the cover part in an elastically preloaded manner.

In some embodiments, the step of pre-positioning the anti-electromagnetic interference sheet on the printed circuit board comprises: inserting the plug-in part of the anti-electromagnetic interference sheet into the groove of the printed circuit board, such that the extension section of the plug-in part is supported on the inner wall of the groove in a preloaded manner.

In some embodiments, the step of fixedly connecting the anti-electromagnetic interference sheet to the printed circuit board comprises: threading the anti-electromagnetic interference sheet to the printed circuit board by mounting a bolt into the through hole in the bent part of the anti-electromagnetic interference sheet and the mating through hole in the printed circuit board.

To solve the technical problems mentioned, the present disclosure also provides a vehicle, comprising the electrical device described above. The vehicle may be a plug-in hybrid electric vehicle, or a battery electric vehicle or another type of motor vehicle. Based on the above, the vehicle can realize the functions of the electrical device described above, and has the advantages described above.

### Brief Description of the Drawings

In order to give a clearer explanation of the technical solutions of embodiments of the present disclosure, the drawings of the embodiments will be briefly described below; obviously, the drawings in the following description only relate to some embodiments of the present disclosure, and do not limit it.
Fig. 1 is a partial 3D drawing of an assembled electrical device according to the present disclosure.
Fig. 2 is an exploded drawing of the electrical device shown in Fig. 1.
Fig. 3 is a partial 3D drawing of the anti-electromagnetic interference sheet of the electrical device shown in Fig. 1.
Fig. 4 is an exemplary flow chart of a method for assembling an electrical device according to an embodiment of the present disclosure; and
Fig. 5 is a 3D drawing of an anti-electromagnetic interference sheet and a printed circuit board in an assembled state.

### Key to the drawings:

- 1: Cover part
- 2: Printed circuit board
- 21: Mating through hole
- 22: Groove
- 221: First area
- 222: Second area
- 3: Anti-electromagnetic interference sheet
- 31: Bent part
- 31a: Through hole
- 32: Contact arm
- 33: Plug-in part
- 33a: Extension section
- 34: Projection
- 400: Method
- S401: Step
- S402: Step
- S403: Step

### Detailed Description of Embodiments

The technical solution in embodiments of the present disclosure will be described clearly and completely below with reference to the drawings in embodiments of the present disclosure. Obviously, the embodiments described are only some, not all, of the embodiments of the present disclosure. All other embodiments obtained by those skilled in the art based on embodiments in the present disclosure without inventive effort shall fall within the scope of protection of the present disclosure.

The expression "an embodiment" or "embodiment" as used herein means a specific feature, structure or characteristic that may be included in at least one implementation of the present disclosure. In the description of the present disclosure, it should be understood that orientational or positional relationships indicated by the terms "up", "down", "left", "right", "top", "bottom", etc. are based on the orientational or positional relationships shown in the drawings, and are merely intended to facilitate and simplify the description of the present disclosure, rather than indicating or implying that the apparatus or element referred to must have a specific orientation or be constructed and operated in a specific orientation, and therefore should not be construed as limiting the present disclosure.

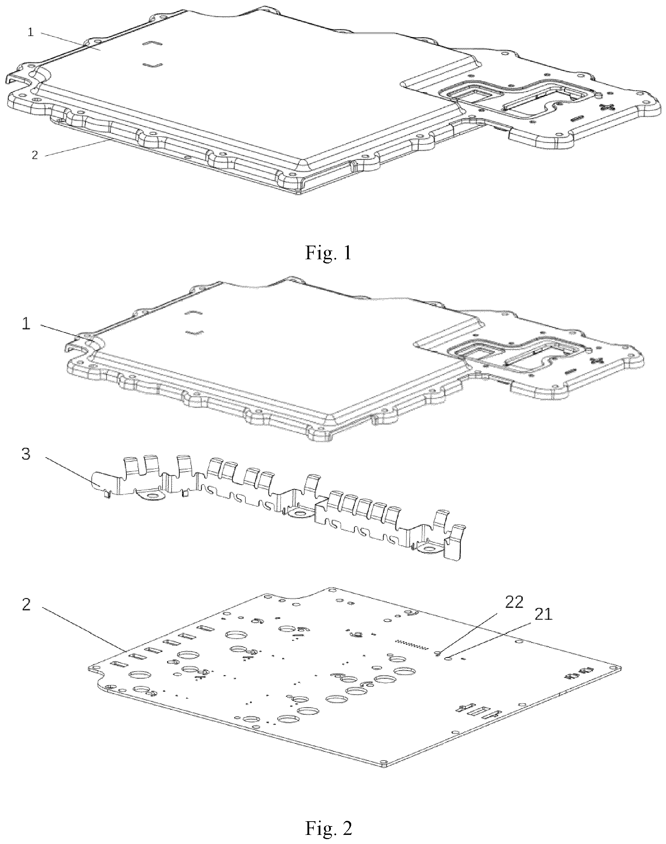

Fig. 1 is a partial 3D drawing of an electrical device according to an embodiment of the present disclosure. The electrical device in the shown embodiment is an inverter. Of course, in embodiments which are not shown, the electrical device may also be another electrical device that produces electromagnetic radiation during operation.

Fig. 2 is an exploded drawing of the electrical device shown in Fig. 1. As shown in Fig. 2, the electrical device comprises a cover part 1, a printed circuit board (PCB) 2, and an anti-electromagnetic interference (EMI) sheet 3 arranged between the cover part 1 and the PCB 2, wherein the cover part 1 and the PCB 2 both extend in substantially planar form and are parallel to each other.

A first electronic element and a second electronic element are provided on the PCB 2. The first electronic element and the second electronic element are for example selected from signal connectors, filter components and functional components. The signal connector is for connection to another electrical device, receives a control or feedback signal from the other electrical device, and is capable of outputting a corresponding feedback or control signal to the other electrical device. A signal received or outputted via said signal connector may for example be a voltage signal or a current signal. There are no restrictions on the specific type of electrical device connected to the signal connector or the content of input/output signals of the signal connector.

The filter component is mainly used to prevent noise generated by a device inside the electrical device from radiating to the outside through a connector opening or being conducted to the outside along a cable connected to the connector. In addition, it may also subject AC from an external power grid to filtering, to filter out AC noise therein. It may for example comprise one or more inductor and one or more capacitor.

For example, an input filter component may be disposed at an input connector port on the PCB, and an output filter component may be disposed at an output connector port on the PCB. For example, the input filter component is a two-stage filter component, comprising a first common-mode inductor, a second common-mode inductor, a first input capacitor, and a second input capacitor. The output filter component is a single-stage filter component, comprising a third common-mode inductor and an output capacitor module. The specific composition of the input filter component and the output filter component, and the positions where they are disposed, have no significant impact on the inventive thinking of the present disclosure, so are not shown in more detail in the drawings. It should also be explained that, depending on different actual needs, the filter component may have different compositions and be disposed in different positions.

The functional component is used to perform a corresponding function of the electrical device. For example, the inverter shown in Fig. 1 may comprise a resonant inductor, a transformer, an inductor and multiple transistor zones, and be used to process AC inputted at the input end and convert it into a required voltage, for example into a 400 V DC voltage, or into a 450 V DC voltage. It is not limited to a specific composition of a functional component of said electric apparatus or a specific function fulfilled by it.

Here, to prevent electromagnetic interference between the first electronic element and the second electronic element, the anti-electromagnetic interference sheet 3 is used to divide the PCB 2 into zones, so as to block mutual interference of electromagnetic signals between the first electronic element and second electronic element.

As shown in Fig. 2, the anti-electromagnetic interference sheet 3 is formed as an independent sheet-like structure, and functions to block outward electromagnetic radiation produced by a functional module within the electrical device, e.g. prevent noise generated by an internal device from radiating to the outside through a connector opening or being conducted to the outside along a cable connected to the connector, so as to reduce electromagnetic interference to an external device therefrom, and increase the electromagnetic compatibility (EMC) of the electrical device. In some embodiments, the anti-electromagnetic interference sheet 3 is designed as a stamping part formed as a single piece. In the embodiment shown, the anti-electromagnetic interference sheet 3 is made as a thin plate from copper, and its maximum dimension in a planar direction parallel to the PCB 2 is much greater than its maximum dimension in a planar direction perpendicular to the PCB 2, i.e. a height direction. It must be explained that other suitable electrically conductive materials may also be used to make the anti-electromagnetic interference sheet.

Here, the anti-electromagnetic interference sheet 3 does not necessarily extend perfectly straight, and instead may extend in a "meandering" fashion as shown in Fig. 2 to Fig. 3, i.e. be bent in a longitudinal direction, so as to satisfy the requirement to partition an interior space of the electrical device into areas.

One side of the anti-electromagnetic interference sheet 3 is fixedly mounted on the PCB 2, and another side thereof is in contact with the cover part 1, thereby dividing the interior space defined by the cover part 1 and the PCB 2 into two areas, specifically a first area 221 and a second area 222 which are functionally different, in particular, different in terms of electromagnetic radiation properties, wherein the first electronic element is arranged in the first area 221, and the second electronic element is arranged in the second area 222. It should be explained here that the internal space could of course be divided into more than two areas as required.

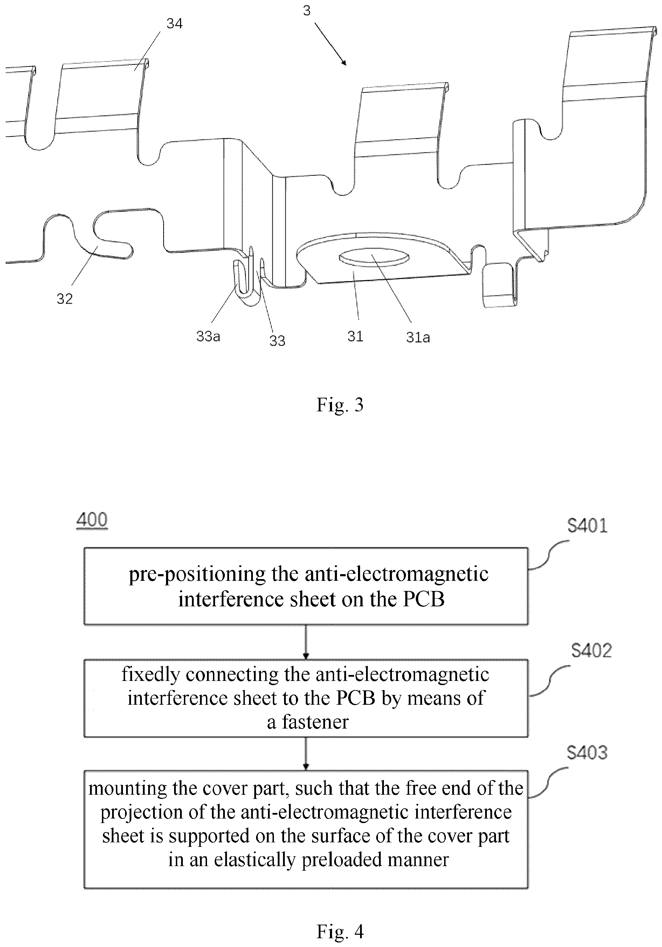

Fig. 3 is a partial 3D drawing of the anti-electromagnetic interference sheet of the electrical device shown in Fig. 1.

As shown in Fig. 3, a bent part 31, a contact arm 32 and a plug-in part 33 are comprised at the side of the anti-electromagnetic interference sheet 3 that is connected to the PCB 2.

The plug-in part 33 extends downwards from a body of the anti-electromagnetic interference sheet 3, and comprises an elastically deformable extension section 33a on a free end thereof. In the embodiment shown, the extension section 33a is formed as a bent hook-shaped section, but in embodiments which are not shown, the extension section 33a may also be formed as a tapered section or in any other shape, as long as it is elastically deformable. Correspondingly, the PCB 2 comprises a groove 22; the extension section 33a of the plug-in part 33 can be inserted in the groove 22, such that the extension section 33a is supported on an inner wall of the groove 22 in a preloaded manner, so that the groove 22 clamps the plug-in part 33.

Thus, the anti-electromagnetic interference sheet and the PCB are pre-positioned relative to each other before being finally connected together; this makes it easier for the anti-electromagnetic interference sheet to be fixedly connected to the PCB with accurate positioning in a simple process, and reduces costs in comparison with the use of a tool to pre-position the anti-electromagnetic interference sheet.

The bent part 31 is bent perpendicularly from the body of the anti-electromagnetic interference sheet 3, and faces the plane of the PCB 2. The bent part 31 comprises a through hole 31a, and correspondingly, a mating through hole 21 is formed on the PCB 2; a fastener can simultaneously pass through the through hole 31a and the mating through hole 21, in order to assemble the anti-electromagnetic interference sheet 3 and the PCB 2 in a fixed manner. In some embodiments, the fastener may be a bolt, and the anti-electromagnetic interference sheet 3 and the PCB 2 are assembled in a fixed manner by tightening the bolt. In embodiments which are not shown, other fasteners may be used, e.g. rivets, pins, etc. Thus, a firm and reliable fixed connection between the anti-electromagnetic interference sheet and the PCB is accomplished in a simple manner; compared with a soldering process, the use of a fastener for assembly is simpler and reduces costs.

The contact arm 32 is bent in a direction of extension of the body of the anti-electromagnetic interference sheet 3. In the assembled state of the anti-electromagnetic interference sheet 3 and the PCB 2, the contact arm 32 abuts a surface of the PCB 2 adjacent to the anti-electromagnetic interference sheet 3 in a preloaded manner.

As shown in Fig. 3, multiple projections 34 are comprised at the side of the anti-electromagnetic interference sheet 3 that is adjacent to the cover part 1, the projections 34 likewise being elastically deformable. In the assembled state of the electrical device, free ends of the projections 34 are supported on a surface of the cover part 1 that is adjacent to the anti-electromagnetic interference sheet 3, in an elastically preloaded manner.

Thus, an upper side and a lower side of the anti-electromagnetic interference sheet 3 are in reliable contact with the cover part 1 and the PCB 2 respectively, thereby ensuring stable anti-electromagnetic interference performance.

Fig. 4 is an exemplary flow chart of a method 400 for assembling an electrical device provided in an embodiment of the present disclosure.

Referring to Fig. 4, firstly, in step S401, the anti-electromagnetic interference sheet 3 is pre-positioned on the PCB 2. In this process, the plug-in part 33 at the lower side of the anti-electromagnetic interference sheet 3 is inserted in the groove 22 of the PCB 2, such that the extension section 33a of the plug-in part 33 is supported on the inner wall of the groove 22 in an elastically preloaded manner, so that the plug-in part 33 is clamped in the groove 22, thus realizing pre-positioning of the anti-electromagnetic interference sheet 3 and the PCB 2. At this time, the contact arm 32 at the lower side of the anti-electromagnetic interference sheet 3 also abuts the surface of the PCB 2, and the bent part 31 is fitted tightly against the surface of the PCB 2.

Next, in step S402, the anti-electromagnetic interference sheet 3 is fixedly connected to the PCB 2 by means of a fastener. In this process, a bolt is simultaneously passed through the through hole 31a in the bent part 31 and the mating through hole 21 in the PCB 2 and tightened, so as to fixedly connect the anti-electromagnetic interference sheet 3 to the PCB 2.

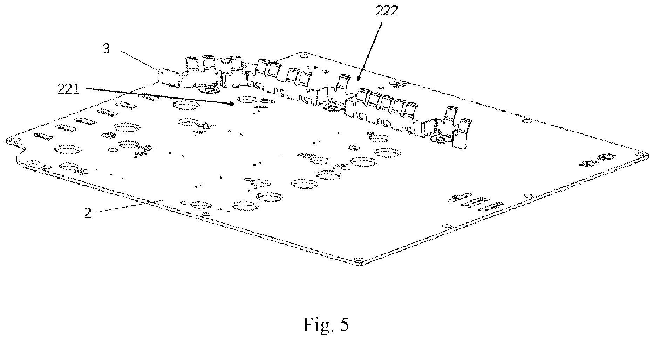

Fig. 5 is a schematic drawing of the anti-electromagnetic interference sheet 3 and the PCB 2 in an assembled state.

Finally, in step S403, the cover part 1 is mounted. In this process, the cover part 1 is used to close the electrical device from above, and the free ends of the projections 34 at the upper side of the anti-electromagnetic interference sheet 3 are supported on the surface of the cover part 1 that is adjacent to the anti-electromagnetic interference sheet 3, in an elastically preloaded manner.

Utilizing the pre-positioning of the anti-electromagnetic interference sheet by the plug-in part, followed by fixed mounting of the anti-electromagnetic interference sheet with the aid of fasteners, in particular bolts, the electrical device thereby obtained and such an assembly method realize simple and convenient mounting of the electrical device comprising the anti-electromagnetic interference sheet, and considering the advantages of fasteners in terms of process difficulty, required man-hours and connection quality, lower mounting costs and a better quality result are achieved, thus achieving more stable anti-electromagnetic interference performance.

Embodiments of the present disclosure further provide a vehicle, comprising an electrical device provided in at least one embodiment of the present disclosure. The vehicle may be an electrified vehicle, such as a battery electric vehicle (BEV), a hybrid electric vehicle (HEV), a plug-in hybrid electric vehicle (PHEV), a range extended EV and a fuel cell electric vehicle (FCEV). The vehicle may also be a hydrogen-powered vehicle.

As a result of comprising the electrical device described above in the vehicle, assembly can be simplified and costs can be reduced while preventing electromagnetic interference when the electrical device performs its corresponding functions.

Certain features, structures or characteristics in one or more embodiments of the present application may be combined appropriately.

Unless otherwise defined, all of the terms (including technical and scientific terms) used herein have the same meanings as those commonly understood by those skilled in the art. It should also be understood that terms such as those defined in a common dictionary should be interpreted as having the same meanings as they have in the context of the related art, rather than being interpreted in an idealized or extremely formalized sense, unless expressly so defined herein.

The above is a description of the present disclosure, and should not be regarded as limiting it. Although some exemplary embodiments of the present disclosure have been described, those skilled in the art will readily understand that many modifications could be made to the exemplary embodiments without departing from the original teaching and advantages of the present disclosure. Therefore, all such modifications are intended to be included in the scope of the present disclosure as defined by the claims. It should be understood that the above is a description of the present disclosure, and the present disclosure should not be regarded as being limited to the specific embodiments disclosed; moreover, modifications to the disclosed embodiments and other embodiments are intended to be included in the scope of the present disclosure.

## Claims

1. An electrical device, **characterized in that** the electrical device comprises:
a cover part (1);
a printed circuit board (2); and
an anti-electromagnetic interference sheet (3);
the anti-electromagnetic interference sheet (3) is arranged between the cover part (1) and the printed circuit board (2), and the anti-electromagnetic interference sheet (3) is fixedly connected to the printed circuit board (2) by means of a fastener.

2. The electrical device according to claim 1, **characterized in that** the anti-electromagnetic interference sheet (3) comprises a plug-in part (33) on its side connected to the printed circuit board (2), a free end of the plug-in part (33) comprises an elastically deformable extension section (33a), the printed circuit board (2) comprises a groove (22) cooperating with the plug-in part (33), and the extension section (33a) is supported on an inner wall of the groove (22) in a preloaded manner in an installed state of the electrical device.

3. The electrical device according to claim 1, **characterized in that** the anti-electromagnetic interference sheet (3) is in threaded connection with the printed circuit board by means of a bolt.

4. The electrical device according to claim 1, **characterized in that** the anti-electromagnetic interference sheet (3) comprises a bent part (31) on its side connected to the printed circuit board (2), the bent part (31) comprises a through hole (31a), and the through hole (31a) is for the fastener to pass through and corresponds to a mating through hole (21) of the printed circuit board (2).

5. The electrical device according to claim 1, **characterized in that** the anti-electromagnetic interference sheet (3) comprises a contact arm (32) on its side connected to the printed circuit board (2), and the contact arm (32) abuts against a surface of the printed circuit board (2) in an installed state of the electrical device.

6. The electrical device according to claim 1, **characterized in that** the anti-electromagnetic interference sheet (3) comprises an elastically deformable projection (34) on its side adjacent to the cover part (1), and a free end of the projection (34) is supported on the surface of the cover part (1) in an elastically preloaded manner in an installed state of the electrical device.

7. The electrical device according to claim 1, **characterized in that** the printed circuit board (2) comprises a first electronic element and a second electronic element, the electrical device comprises a first area and a second area, the first electronic element is located in the first area, the second electronic element is located in the second area, and the anti-electromagnetic interference sheet is used to prevent electromagnetic interference between the first electronic element and the second electronic element.

8. The electrical device according to claim 1, **characterized in that** the anti-electromagnetic interference sheet (3) is designed as a stamping part formed as a single piece.

9. A method for assembling the electrical device according to any one of claims 1 to 8, comprising:
pre-positioning the anti-electromagnetic interference sheet (3) on the printed circuit board (2);
fixedly connecting the anti-electromagnetic interference sheet (3) to the printed circuit board (2) by means of a fastener; and
mounting the cover part (1) so that the free end of the projection (34) of the anti-electromagnetic interference sheet (3) is supported on the surface of the cover part (1) in an elastically preloaded manner.

10. The method according to claim 9, **characterized in that**,
pre-positioning the anti-electromagnetic interference sheet (3) on the printed circuit board (2) comprises:
inserting the plug-in part (33) of the anti-electromagnetic interference sheet (3) into the groove (22) of the printed circuit board (2), so that the extension section (33a) of the plug-in part (33) is supported on the inner wall of the groove (22) in a preloaded manner.

11. The method according to claim 9, **characterized in that**,
fixedly connecting the anti-electromagnetic interference sheet (3) to the printed circuit board (2) by means of a fastener comprises:
threading the anti-electromagnetic interference sheet (3) to the printed circuit board (2) by installing the bolt to the through hole (31a) of the bent part (31) of the anti-electromagnetic interference sheet (3) and the mating through hole (21) of the printed circuit board (2).

12. A vehicle, **characterized in that** the vehicle comprises the electrical device according to any one of claims 1-8.
